# EUROPEAN PATENT SPECIFICATION

(11) **EP 4 652 450 B1**
(45) Date of publication and mention of the grant of the patent: **04.11.2026**
(21) Application number: 24701799.9
(22) Date of filing: 17.01.2024
(51) Int. Cl.: G01N 24/08, G01R 33/46

(54) **METHODS OF QUANTIFYING SAPONINS PRESENT IN PARTICLES COMPRISING SAPONIN AND LIPID**
VERFAHREN ZUR QUANTIFIZIERUNG VON SAPONINEN IN TEILCHEN MIT SAPONIN UND LIPID
PROCÉDÉS DE QUANTIFICATION DE SAPONINES PRÉSENTES DANS DES PARTICULES COMPRENANT DE LA SAPONINE ET UN LIPIDE

(30) Priority: 18.01.2023 US 202363480326 P
(43) Date of publication of application: 26.11.2025
(73) Proprietor: Novavax AB, 753 18 Uppsala (SE)
(72) Inventor: RUNDLÖF, Torgny, 753 18 Uppsala (SE); MOJARRADI, Hotan, 753 18 Uppsala (SE); BANKEFORS, Johan, 753 18 Uppsala (SE)
(74) Representative: Novitas Patent AB
(86) International application number: PCT/EP2024/050982
(87) International publication number: WO 2024/153674

(56) References cited:
- BEHBOUDI S ET AL: "Isolation and quantification of Quillaja saponaria Molina saponins and lipids in iscom-matrix and iscoms", VACCINE, ELSEVIER, AMSTERDAM, NL, vol. 13, no. 17, 1 December 1995 (1995-12-01), pages 1690 - 1696, XP004057399, ISSN: 0264-410X, DOI: 10.1016/0264-410X(95)00107-C
- ZHAO HUA ET AL: "Quantitative 1H NMR for the Direct Quantification of Saikosaponins in Bupleurum chinense DC.", ANALYTICAL SCIENCES, vol. 37, no. 10, 26 March 2021 (2021-03-26), JP, pages 1413 - 1418, XP093143403, ISSN: 0910-6340, Retrieved from the Internet <URL:https://www.jstage.jst.go.jp/article/analsci/37/10/37_20P462/_pdf/-char/ja> DOI: 10.2116/analsci.20P462

## Description

### TECHNICAL FIELD OF THE INVENTION

The present invention relates generally to methods of quantifying saponins present in particles comprising saponin and lipid, and more particularly to methods of quantifying saponins present in particles comprising saponin and lipid, wherein the saponins of the particles comprise a triterpene core comprising a C26 methyl group comprising three protons.

### BACKGROUND OF THE INVENTION

Saponins are a large family of glycoconjugates that share a triterpene structure with a variety of glycoside side chains and that can have potent immune-stimulating properties. Saponins extracted from the bark of the South American soapbark tree *Quillaja saponaria* Molina contain a complex heterogeneous mixture of closely related saponins with structurally different glycosylation or acylation patterns that affect their biological activities. *Quillaja saponaria* Molina saponins can have a high degree of glycosyl O-acylation, a low degree of glycosyl O-acylation, or no glycosyl O-acylation in their naturally occurring forms. Saponins also can be chemically modified, for example by partial or complete deacylation or degradation.

Saponins of *Quillaja saponaria* Molina in particular can have potent adjuvant activity, but also can be chemically unstable, show hemolytic activity, and be associated with immediate pain at injection sites. Saponin preparations based on defined compositions of purified saponin fractions of *Quillaja saponaria* Molina are described, for example, by Cox et al., PCT/AU1995/000670 (WO96011711).

Incorporation of saponins of *Quillaja saponaria* Molina into particles comprising saponin and lipid can attenuate the chemical instability, hemolytic activity, and immediate pain when injected associated with saponins. Examples of particles comprising saponin and lipid include iscom matrix particles, iscom antigen-presenting particles, liposome-based Adjuvant System 01 particles, and Army Liposome Formulation Q particles, as taught, for example, by Stertman et al., Human Vaccines & Immunotherapeutics, 2023, 19(1):2189885.

Iscom matrix particles, also termed iscom matrix or Matrix, are distinct and stable nanostructures that are produced from saponins, phospholipids, such as phosphatidylcholines, and cholesterol. Iscom matrix particles are described, for example, in Morein et al., PCT/SE1989/000528 (WO9003184), and Morein et al., PCT/SE2003/001180 (WO2004004762). Iscom matrix particles exhibit potent adjuvant activity similarly as for saponins, but with attenuation of the chemical instability, hemolytic activity, and immediate pain when injected associated with saponins.

Iscom antigen-presenting particles, also termed iscom particles or ISCOMs, are stable nanostructures made by coformulation of antigens with saponins, phospholipids, and cholesterol. Iscom antigen-presenting particles are described, for example, in Morein et al, PCT/SE1986/000480 (WO87002250), and Morein et al., PCT/SE2003/001180 (WO2004004762). Iscom antigen-presenting particles include multiple copies of antigens physically incorporated into a matrix of the saponins, phospholipids, and cholesterol. Like iscom matrix particles, iscom antigen-presenting particles also exhibit potent adjuvant activity, but with attenuation of the chemical instability, hemolytic activity, and immediate pain when injected associated with saponins.

Liposome-based Adjuvant System 01 particles are a liposome-based vaccine adjuvant including *Quillaja saponaria* Molina saponin QS-21 and 3-*O*-desacyl-4'-monophosphoryl lipid A, as described, for example, in Didierlaurent et al., Expert Review of Vaccines, 2017, 16(1):55-63. According to Didierlaurent et al. (2017), incorporation of the QS-21 saponin in the liposome-based Adjuvant System 01 particles eliminates hemolytic activity of the saponin.

Army Liposome Formulation Q particles are a liposome-based vaccine adjuvant including *Quillaja saponaria* Molina saponin QS-21, saturated phospholipids, cholesterol, and monophosphoryl lipid A, as described, for example, by Alving et al., Expert Review of Vaccines, 2020, 19(3):279-292. According to Alving et al. (2020), incorporation of the QS-21 saponin in the Army Liposome Formulation Q particles quenches hemolytic activity of the saponin against erythrocytes.

As noted, particles comprising saponin and lipid such as iscom matrix particles, iscom antigen-presenting particles, liposome-based Adjuvant System 01 particles, and Army

Liposome Formulation Q particles are composed of saponins and other components. The exact saponin concentration in the particles often needs to be determined during product development. For most analytical techniques, quantification of the saponin concentration would involve the use of an appropriate saponin reference standard. Unfortunately, most often, such standards are not available, limiting the availability of analytical techniques for quantifying saponins in particles comprising saponin and lipid.

Serving as an example, document BEHBOUDI S ET AL: "Isolation and quantification of Quillaja saponaria Molina saponins and lipids in iscom-matrix and iscoms", VACCINE, ELSEVIER, AMSTERDAM, NL, vol. 13, no. 17, 1 December 1995 (1995-12-01), pages 1690-1696, ISSN: 0264-410X, DOI: 10.1016/0264-410X(95)00107-C discloses the quantification of Quillaja triterpenoid saponins and lipids incorporated into iscom-matrix and iscoms (i.e. particles comprising saponin and lipid), by employing a chloroform-methanol-water liquid-liquid extraction to separate a triterpenoid phase from a lipid phase, and quantifying the saponins by HPLC and by orcinol-sulfuric acid colorimetry.

Nuclear magnetic resonance (NMR) spectroscopy techniques, particularly quantitative proton NMR (also qNMR, proton NMR, or 1H-NMR) techniques, could allow for determination of saponin concentrations in liquid compositions towards a universal reference standard, most often named and used as an internal standard. Throughout this disclosure "proton" in the context of NMR refers to 1H nuclei.

Quantitative proton NMR spectroscopy involves a repetitive single-pulse NMR experiment with proton detection where sample conditions and experimental settings have been adjusted so as to ensure complete quantitative signal response. Important parameters include, for example, choice of signal, relaxation delay, and digital resolution. The spectral processing procedure should be robust. Signal responses are preferably measured as peak areas but peak heights may be used in special cases. The resulting signal responses are easily converted to molar ratios and/or concentrations.

Accordingly, quantitative proton NMR spectroscopy can be used as an analytical methodology for quantification of compounds that include protons. Quantification by proton NMR is based on signal comparison, as the signal is directly proportional to the number of protons with the same resonance frequency. The ratio of the signal area observed in the NMR spectrum is proportional to the ratio of the number of nuclei at the respective molecular site. The ratio of the signal intensity observed also can be used instead as an alternative, though this is less preferable. In absolute quantitation, one signal of an analyte is compared to a signal from an internal reference standard. Furthermore, a normalization procedure can be applied by comparing two or more signals in a mixture of components, each signal giving the molar amount of the molecular structure it represents.

Several factors complicate the use of quantitative proton NMR spectroscopy techniques for determining saponin concentrations in liquid compositions including particles comprising saponin and lipid, though. Adding particles comprising saponin and lipid to liquids such as aqueous salt solutions results in formation of dispersions of the particles in the liquids, not solutions. Moreover, the dispersed particles are inappropriate for solution NMR spectroscopy due to slow molecular tumbling and rapid NMR relaxation caused by their relatively large sizes. Additionally, the presence of components other than the saponins in the particles and the rest of the compositions complicates direct measurement on samples.

Accordingly, a need exists for analytical techniques for quantifying saponins present in particles comprising saponin and lipid, and particularly for quantitative proton NMR spectroscopy techniques for doing so.

### SUMMARY OF THE INVENTION

A method of quantifying saponins present in particles comprising saponin and lipid is disclosed. The saponins of the particles comprise a triterpene core comprising a C26 methyl group comprising three protons. The method comprises steps of:
(1) isolating the saponins from the lipids of the particles comprising saponin and lipid by reversed phase solid phase extraction of the saponins from a predetermined amount of the particles comprising saponin and lipid, thereby obtaining isolated saponins;
(2) lyophilizing the isolated saponins, thereby obtaining lyophilized saponins;
(3) preparing a solution of the lyophilized saponins and a predetermined amount of an internal standard compound that comprises one or more protons in deuterated methanol;
(4) generating a quantitative proton NMR spectrum of the solution of the lyophilized saponins and the internal standard compound including a signal for the three protons of the C26 methyl group of the triterpene core of the saponins and a signal for the one or more protons of the internal standard compound; and
(5) comparing the signal for the three protons of the C26 methyl group of the triterpene core of the saponins and the signal for the one or more protons of the internal standard compound.

In some embodiments, step (1) comprises steps of:
(1.1) conditioning a reversed phase solid phase extraction sorbent with a polar organic solvent;
(1.2) equilibrating the reversed phase solid phase extraction sorbent with a mixture comprising the polar organic solvent and water;
(1.3) loading the particles comprising saponin and lipid onto the reversed phase solid phase extraction sorbent;
(1.4) washing the reversed phase solid phase extraction sorbent with a mixture comprising the polar organic solvent and water; and
(1.5) eluting the saponins from the reversed phase solid phase extraction sorbent with the polar organic solvent, thereby obtaining the isolated saponins in a mixture comprising the isolated saponins and the polar organic solvent.

In some of these embodiments, the polar organic solvent comprises methanol.

Also in some of these embodiments, the mixtures comprising the polar organic solvent and water in one or more of the steps (1.2) or (1.4) comprise methanol and water at a ratio of 1:99 to 20:80 (V:V), 2:98 to 10:90 (V:V), 3:97 to 7:93 (V:V), or about 5:95 (V:V).

Also in some of these embodiments, during step (1.3) the particles comprising saponin and lipid are loaded onto the reversed phase solid phase extraction sorbent at 0.1 mg to 2 mg saponin content, 0.2 mg to 1 mg saponin content, 0.3 mg to 0.7 mg saponin content, 0.4 mg to 0.6 mg saponin content, or about 0.5 mg saponin content, per 500 mg bed weight of the reversed phase solid phase extraction sorbent.

Also in some of these embodiments, the reversed phase solid phase extraction sorbent comprises an octadecyl sorbent active group.

Also in some of these embodiments, step (1) further comprises a step of (1.6) of adding water to the mixture comprising the isolated saponins and the polar organic solvent to a final water content of 5% to 20%, 7% to 15%, 9% to 12%, or about 10%, by volume.

In some embodiments, the predetermined amount of the particles comprising saponin and lipid is a saponin content of a formulation used to make the particles comprising saponin and lipid.

In some embodiments, the internal standard compound comprises maleic acid and the one or more protons of the internal standard compound comprise two magnetically equivalent olefinic protons of the maleic acid.

In some embodiments, the quantitative proton NMR spectrum is generated according to the following parameters:
(a) a pulse flip angle of 30°;
(b) a relaxation delay of at least 10 seconds; and
(c) an acquisition time of at least 2.7 seconds.

In some of these embodiments, the quantitative proton NMR spectrum is further generated according to one or more of the following parameters:
(d) a temperature of 12-30 °C;
(e) a field strength of at least 400 MHz or at least 600 MHz;
(f) a probe with proton channel having a probe diameter of 1 mm to 10 mm, for example 5 mm;
(g) at least 64 scans or at least 128 scans or at least 256 scans;
(h) a sweep width of at least 12 ppm or at least 16 ppm; or
(i) line broadening function of at least 0.3 Hz or 1 Hz.

In some embodiments, step (5) comprises manual phase correction, automatic polynomial baseline correction, calibration of chemical shift scale, manual polynomial baseline correction, and integration of signals of the quantitative proton NMR spectrum.

In some of these embodiments, the triterpene core of one or more of the saponins further comprises a C23 aldehyde group.

In some of these embodiments, the calibration of chemical shift scale comprises setting a main peak of the C23 aldehyde group to 9.45 ppm.

Also in some of these embodiments, (i) the manual polynomial baseline correction comprises correcting the signal for the three protons of the C26 methyl group of the triterpene core of the saponins at a chemical shift range of 0.60 to 0.85 ppm; and/or (ii) the integration of signals comprises applying integration limits for the signal for the three protons of the C26 methyl group of the triterpene core of the saponins based on a chemical shift range of 0.73 to 0.85 ppm.

In some embodiments, step (5) comprises conducting area normalization of the signal for the three protons of the C26 methyl group of the triterpene core of the saponins and the signal for the one or more protons of the internal standard compound to account for differences in numbers of magnetically equivalent protons thereof.

In some embodiments, the triterpene core of the saponins further comprises a C3 position and a C28 position, and the saponins further comprise a di-saccharide group or a tri-saccharide group attached to the C3 position of the triterpene core, and an oligosaccharide group attached to the C28 position of the triterpene core.

In some of these embodiments, the triterpene core comprises one or more of a Quillaic acid triterpene core, a Quillaic acid 22β-OH triterpene core, a Phytolaccagenic acid triterpene core, a Phytolaccagenic acid 23-OAc triterpene core, a Gypsogenin triterpene core, or an Echinocystic acid triterpene core.

Also in some of these embodiments, the oligosaccharide group comprises a fucosyl group comprising an O-3 position and an O-4 position.

Also in some of these embodiments, one or more of the saponins further comprise a fatty acyl group and/or an acyl II group attached to the O-3 position or the O-4 position of the fucosyl group.

Also in some of these embodiments, the proton NMR spectrum of the solution of the lyophilized saponins and the internal standard further includes a signal for one or more protons of the fatty acyl group attached to the O-3 position or the O-4 position of the fucosyl group, and the method further comprises a step (6) of comparing the signal for the one or more protons of the fatty acyl group attached to the O-3 position or the O-4 position of the fucosyl group to one or more of the signal for the three protons of the C26 methyl group of the triterpene core of the saponins or the signal for the one or more protons of the internal standard compound.

In some embodiments, the saponins comprise saponins extracted from bark of the South American soapbark tree *Quillaja saponaria* Molina.

In some embodiments, the particles comprising saponin and lipid comprise or consist of one or more of iscom matrix particles, iscom antigen-presenting particles, liposome-based Adjuvant System 01 particles, or Army Liposome Formulation Q particles.

In some embodiments, the lipids comprise one or more phospholipids and cholesterol.

In some of these embodiments, the one or more phospholipids comprise one or more phosphatidylcholines.

In some embodiments, the particles comprising saponin and lipid are iscom matrix particles that consist essentially of the saponins, the one or more phospholipids, and the cholesterol.

In some embodiments, the particles comprising saponin and lipid are iscom antigen-presenting particles that consist essentially of the saponins, the one or more phospholipids, the cholesterol, and one or more antigens.

### BRIEF DESCRIPTION OF THE DRAWINGS

FIG. 1 shows common structures of *Quillaja* saponins. The asterisks indicate sites of Fa-2 and Fa-2' protons.
FIG. 2 shows a proton NMR spectrum of a chromatographic fraction of saponins from *Quillaja saponaria* Molina, designated Saponin type II. Peaks for the geminal proton pairs Fa-2 and Fa-2', and methyl Sap26 are indicated.
FIGS. 3A-3C show baseline corrections for a proton NMR spectrum of saponins from a sample of iscom matrix particles. First, as shown in FIG. 3A, the spectrum is corrected in the range of 0-10 ppm. Secondly, as shown in FIG. 3B, the signal at 0.8 ppm (Sap26) is corrected. Finally, as shown in FIG. 3C, the signal at 6.35 (maleic acid) is corrected.
FIG. 4 shows integration for quantitative NMR, corresponding to (A) integration of Sap26 signal (0.0022), and (B) integration of the maleic acid signal (0.0045).
FIG. 5 shows a proton NMR spectrum of a first Matrix type I sample.
FIG. 6 shows a proton NMR spectrum of a second Matrix type I sample.
FIG. 7 shows a proton NMR spectrum of a third Matrix type I sample.
FIG. 8 shows a proton NMR spectrum of first Matrix type II sample.
FIG. 9 shows a proton NMR spectrum of second Matrix type II sample.
FIG. 10 shows a proton NMR spectrum of third Matrix type II sample.

### DETAILED DESCRIPTION OF THE INVENTION

Surprisingly, we have determined that saponins present in particles comprising saponin and lipid can be quantified by a method comprising steps of: (1) isolating the saponins from lipids of the particles by reversed phase solid phase extraction of the saponins from a predetermined amount of the particles; (2) lyophilizing the isolated saponins; (3) preparing a solution of the lyophilized saponins and a predetermined amount of an internal standard compound in deuterated methanol; (4) generating a quantitative proton NMR spectrum of the solution of the lyophilized saponins and the internal standard compound including a signal for three protons of a C26 methyl group of a triterpene core of the saponins and a signal for one or more protons of the internal standard compound; and (5) comparing the signal for the three protons of the C26 methyl group of the triterpene core and the signal for the one or more protons of the internal standard compound.

Focusing on iscom matrix particles in particular, we determined that a pre-treatment step involving subjecting predetermined amounts of iscom matrix particles in known volumes of samples of dispersions of the iscom matrix particles in aqueous salt solutions to reversed phase solid phase extraction causes disintegration of the iscom matrix particles during the reversed phase solid phase extraction and allows isolation of the saponins from other components present in the samples sufficiently to quantify the isolated saponins by qNMR. We also determined that by subjecting predetermined amounts of the iscom matrix particles in the known volumes of samples to the reversed phase solid phase extraction, with the predetermined amounts measured in terms of the saponin contents of formulations that had been used to make the iscom matrix particles in the first place, the qNMR results for the isolated saponins can be used to quantify the saponins present in the iscom matrix particles of the samples.

Specifically, we tested several solvent systems and reversed phase solid phase extraction sorbents, resulting in a method comprising a methanol-water system and an octadecyl sorbent active group (also termed C18). We observed reasonable saponin recoveries and good repeatability, with the other components, particularly lipids and salts, either being retained on the sorbent, in the case of the lipids, or being washed away, in the case of the salts. We quantitatively collected the eluted saponins, added water to prevent degradation, and lyophilized the resulting solutions.

We then redissolved the dried extracts in perdeuterated methanol together with an internal standard that was previously dissolved in perdeuterated water. We determined suitable conditions for quantitative proton NMR spectroscopy with respect to peak selection, digital resolution, relaxation (repetition) delay, and signal-to-noise ratio. Furthermore, we determined suitable data processing conditions, including phase and baseline correction and integration limits. We calculated molar ratios from peak integrals of selected saponin and internal standard peaks in the resulting NMR spectra, after correction with respect to the number of protons comprised in respective peaks.

Based on our approach, we determined that the molar amounts of saponins in NMR samples could be calculated since the amount of internal standard was known. Moreover, by having subjected predetermined amounts of the iscom matrix particles in known volumes of samples to the reversed phase solid phase extraction, we were able to relate the molar amounts of the saponins in the NMR samples to the molar amounts of the saponins in the iscom matrix samples.

Our method should be applicable to other particles comprising saponin and lipid too, such as iscom antigen-presenting particles, liposome-based Adjuvant System 01 particles, or Army Liposome Formulation Q particles, also based on using reversed phase solid phase extraction to disintegrate the other particles and isolation of saponins of the disintegrated particles.

Considering iscom antigen-presenting particles in particular, iscom antigen-presenting particles are typically made from protein antigen solutions including the nonionic surfactant polysorbate 80 (PS-80), Triton or NP-40 to stabilize the antigen and form the iscom antigen-presenting particles. Like the lipids of iscom matrix particles, the lipids of iscom antigen-presenting particles and the nonionic surfactant (e.g. polysorbate 80) would be retained on the sorbent. Minor amounts of impurities and degradants of the nonionic surfactant (e.g. polysorbate 80) might co-elute with the saponins, but would not be expected to interfere with the integration of signals in NMR.

Thus, a method of quantifying saponins present in particles comprising saponin and lipid is disclosed.

The particles comprise the saponins and lipids. The particles can comprise or consist of, for example, one or more of iscom matrix particles, iscom antigen-presenting particles, liposome-based Adjuvant System 01 particles, or Army Liposome Formulation Q particles, among other particles comprising saponin and lipid.

Iscom matrix particles can be made as described, for example, in Morein et al., PCT/SE1989/000528, and Morein et al., PCT/SE2003/001180. As taught by Morein et al., PCT/SE2003/001180, iscom matrix particles constitute Quillaja saponin, cholesterol and phospholipid. These particles may be present in a mixture with antigens, but would not be associated with the antigens.

Iscom antigen-presenting particles can be made as described, for example, in Morein et al., PCT/SE1989/000528, and Morein et al., PCT/SE2003/001180. As taught by Morein et al., PCT/SE2003/001180, iscom antigen-presenting particles are nanoparticle complexes including Quillaja saponins, cholesterol, and phospholipids into which vaccine antigens are incorporated.

Liposome-based Adjuvant System 01 particles are described, for example, in Didierlaurent et al., Expert Rev Vaccines 2017, 16(1):55-63.

Army Liposome Formulation Q particles are described, for example, by Alving et al., Expert Rev Vaccines 2020, 19(3):279-292.

The lipids of the particles can comprise, for example, one or more phospholipids and cholesterol. The one or more phospholipids can comprise, for example, one or more phosphatidylcholines. These are the lipids of iscom matrix particles and iscom antigen-presenting particles.

Thus, in some embodiments, the particles are iscom matrix particles that consist essentially of the saponins, the one or more phospholipids, and the cholesterol. These are the components that provide for the structure and function of iscom matrix particles.

Also in some embodiments, the particles are iscom antigen-presenting particles that consist essentially of the saponins, the one or more phospholipids, the cholesterol, and one or more antigens. These are the components that provide for the structure and function of iscom antigen-presenting particles.

The saponins comprise a triterpene core comprising a C26 methyl group comprising three protons. The saponins can comprise, for example, saponins extracted from bark of the South American soapbark tree *Quillaja saponaria* Molina.

*Quillaja saponaria* Molina saponins generally comprise three main moieties: (1) a triterpene core, typically a Quillaic acid triterpene core but also to some extent Quillaic acid 22β-OH, Phytolaccagenic acid, Phytolaccagenic acid 23-OAc, Gypsogenin or Echinocystic acid triterpene cores, including a C26 methyl group (also termed Sap26 methyl group), a C3 position, and a C28 position; (2) a di-/tri-saccharide attached to the C3 position of the triterpene core; and (3) an oligosaccharide attached to the C28 position of the triterpene core. The triterpene core optionally can further comprise a C23 aldehyde group (also termed Sap23 aldehyde group). Quillaic acid, Gypsogenin and Echinocystic acid triterpene cores comprise the C23 aldehyde group. The oligosaccharide optionally can contain an acyl group.

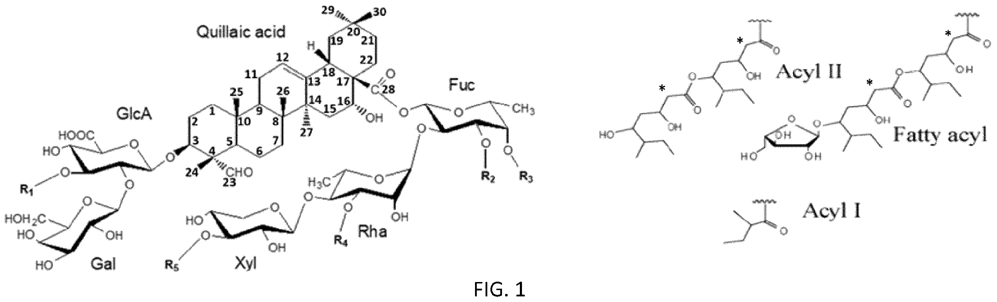

For common structures of *Quillaja* saponins, see FIG. 1 and TABLE 1.

**TABLE 1. Complementary information to FIG. 1, showing the different structural possibilities for the major components of samples that contain Quillaja saponins.**

| **R group** | **R₁** | **R₂ (Fucose O-3 position)** | **R₃ (Fucose O-4 position)** | **R₄** | **R₅** |
|---|---|---|---|---|---|
| **Identity** | H, Rha, Xyl | H, Rha, Glc, Glc60Ac, Acetyl, Acyl I, Acyl II, Fatty acyl | H, Acetyl, Acyl I, Acyl II, Fatty acyl | H, Glc, Acetyl | H, Xyl, Xyl-Xyl, Api-Xyl |

Saponin materials may be divided into different categories with respect to the acyl groups in TABLE 1. Saponin type I may contain small amounts of Acyl I but no Fatty acyl or Acyl II, while saponin type II may contain high amounts of Fatty acyl and/or Acyl II but only traces of Acyl I. A third type, saponin type III, may contain all types of acyl groups.

The degree of fatty acylation is the percentage of Fatty acyl and/or Acyl II groups linked to O-4 or O-3 of the fucosyl residue per triterpene residue.

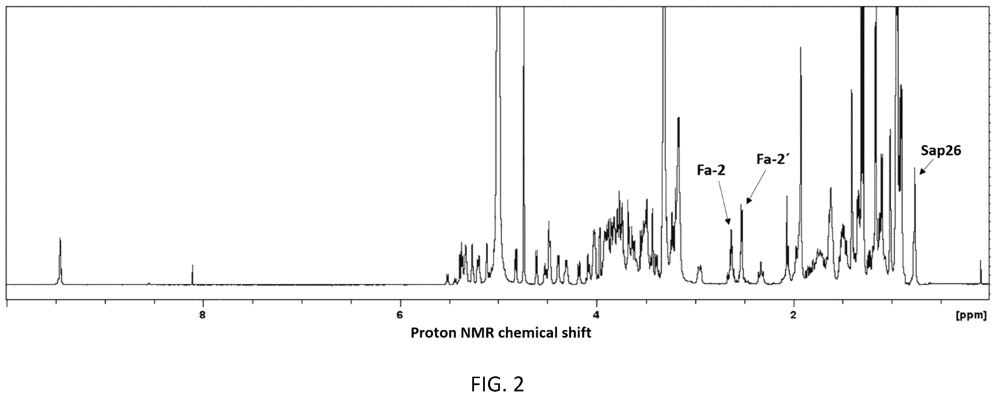

For expected signals see FIG. 2.

The method comprises a step of (1) isolating the saponins from the lipids of the particles comprising saponin and lipid by reversed phase solid phase extraction of the saponins from a predetermined amount of the particles, thereby obtaining isolated saponins.

The predetermined amount of the particles comprising saponin and lipid can be, for example, a saponin content of a formulation used to make the particles. According to this approach, the predetermined amount of the particles is predetermined from the amount of saponins that were included in the formulation used to make the particles, based on assuming incorporation of 100% of the saponins in the formulation into the particles. Thus, for example, according to this approach as applied to iscom matrix particles, the predetermined amount of the iscom matrix particles can be the saponin content of the formulation that was used to make the iscom matrix particles, assuming incorporation of 100% of the saponins into the iscom matrix particles. Likewise, according to this approach as applied to iscom antigen-presenting particles, the predetermined amount of the iscom antigen-presenting particles can be the saponin content of the formulation that was used to make the iscom antigen-presenting particles, assuming incorporation of 100% of the saponins into the iscom antigen-presenting particles. This approach also can be applied regarding Liposome-based Adjuvant System 01 particles and Army Liposome Formulation Q particles, among other particles comprising saponin and lipid.

As noted above, by subjecting predetermined amounts of the iscom matrix particles in known volumes of samples to the reversed phase solid phase extraction, with the predetermined amounts measured in terms of the saponin contents of formulations that had been used to make the iscom matrix particles, the qNMR results for the isolated saponins can be used to quantify the saponins present in the iscom matrix particles of the samples.

According to this approach, in practice the desired sample volume (mL) to load on a reversed phase solid phase extraction sorbent in step (1) can be calculated for example as follows. The amount of the particles comprising saponin and lipid in a sample is defined as the mass (mg) of saponin content of the formulation used to make the particles in the sample, assuming 100% incorporation of saponin into the particles, and is known. The volume (mL) of the sample also is known. Accordingly, the saponin content concentration (mg/mL) can be calculated, again assuming 100% incorporation of saponin into the particles, by dividing the saponin content mass by the sample volume. The desired sample volume to load is then calculated by dividing the desired saponin content for loading, for example, approximately 0.5 mg saponin content, by the concentration of the saponin content of the sample, for example 5 mg/mL, in this example for a loading volume of 0.1 mL.

As will be appreciated, the method disclosed herein can be used for, among other things, determining the actual percentage of incorporation of saponin into particles comprising saponin and lipid during formulation of the particles.

In some embodiments step (1) comprises steps of:
(1.1) conditioning a reversed phase solid phase extraction sorbent with a polar organic solvent;
(1.2) equilibrating the reversed phase solid phase extraction sorbent with a mixture comprising the polar organic solvent and water;
(1.3) loading the particles comprising saponin and lipid onto the reversed phase solid phase extraction sorbent;
(1.4) washing the reversed phase solid phase extraction sorbent with a mixture comprising the polar organic solvent and water; and
(1.5) eluting the saponins from the reversed phase solid phase extraction sorbent with the polar organic solvent, thereby obtaining the isolated saponins in a mixture comprising the isolated saponins and the polar organic solvent.

In some of these embodiments, the polar organic solvent comprises methanol. Methanol is useful for conditioning a reversed phase solid phase extraction sorbent in preparation for isolation of the saponins from the particles comprising saponin and lipid. Mixtures of methanol and water are useful for equilibrating the reversed phase solid phase extraction sorbent. Mixtures of methanol and water also are useful for washing the reversed phase solid phase extraction sorbent to remove salts, particularly from samples of dispersions of the particles comprising saponin and lipid in aqueous salt solutions as loaded onto the reversed phase solid phase extraction sorbent. Methanol also is useful for accomplishing disintegration of the particles comprising the saponin and the lipid in an initial part of the stationary phase of the solid phase extraction, subsequent to loading the particles comprising saponin and lipid. Methanol also is useful for eluting the saponins from the reversed phase solid phase extraction sorbent without eluting the lipids, such as phospholipids and cholesterol, thus providing isolated saponins in a mixture comprising the isolated saponins and methanol, while the lipids are retained on the reversed phase solid phase extraction sorbent.

The mixtures comprising the polar organic solvent and water in one or more of the steps (1.2) or (1.4) can comprise methanol and water at a ratio of, for example, 1:99 to 20:80 (V:V), 2:98 to 10:90 (V:V), 3:97 to 7:93 (V:V), or about 5:95 (V:V), among other ratios.

As will be appreciated, polar organic solvent(s) other than methanol also may be used for one or more of the conditioning, accomplishing disintegration of the particles comprising saponins and lipids, and the eluting the saponins without eluting the lipids. Such polar organic solvent(s) may also be used in combination with methanol.

Moreover, mixtures of other polar organic solvent(s) including or excluding methanol, and water, may be used for the equilibrating and the washing, and may comprise the other polar organic solvents and water at a ratio of, for example, 1:99 to 20:80 (V:V), 2:98 to 10:90 (V:V), 3:97 to 7:93 (V:V), or about 5:95 (V:V), among other ratios.

The particles comprising saponin and lipid can be loaded onto the reversed phase solid phase extraction sorbent in step (1.3) as a liquid dispersion of the particles in an aqueous salt solution. This is a common format for example, for formulating and testing iscom matrix particles and iscom antigen-presenting particles. Conveniently, this format also works well for the loading onto the reversed phase solid phase extraction sorbent.

As noted above, the predetermined amount of the particles comprising saponin and lipid can be, for example, a saponin content of a formulation used to make the particles. During step (1.3) the particles can be loaded onto the reversed phase solid phase extraction sorbent, for example, at 0.1 mg to 2 mg saponin content, 0.2 mg to 1 mg saponin content, 0.3 mg to 0.7 mg saponin content, 0.4 mg to 0.6 mg saponin content, or about 0.5 mg saponin content, per 500 mg bed weight of the reversed phase solid phase extraction sorbent. According to the approach discussed above for calculating the desired sample volume to load on a reversed phase solid phase extraction sorbent, samples of liquid dispersions of the particles having saponin contents in these ranges of 0.1 mg to 2 mg, 0.2 mg to 1 mg, 0.3 mg to 0.7 mg, 0.4 mg to 0.6 mg, or about 0.5 mg, and having a saponin content concentration of approximately 5 mg/mL, would have desired sample loading volumes of approximately 0.02 to 0.4 mL, 0.04 to 0.2 mL, 0.06 to 0.14 mL, 0.08 to 0.12 mL, or about 0.1 mL.

The reversed phase solid phase extraction sorbent can comprise, for example, an octadecyl sorbent active group, among other sorbents. An octadecyl sorbent active group has been determined to be preferable to hydrophilic-lipophilic balanced reversed phase sorbent (also termed HLB) and octyl sorbent (also termed C8) for iscom matrix particles in terms of repeatability and lipid adsorption, but suitability of these and other reversed phase solid phase extraction sorbents for other particles comprising saponin and lipid may vary depending for example on the lipids present in the particles comprising saponin and lipid.

In some embodiments the step (1) further comprises a step of (1.6) of adding water to the mixture comprising the isolated saponins and the polar organic solvent to a final water content of 5% to 20%, 7% to 15%, 9% to 12%, or about 10%, by volume. This can be helpful for preventing methanolysis of the isolated saponins.

Considering step (1) in more detail, loading the particles comprising saponin and lipid onto the reversed phase solid phase extraction sorbent in amounts well below conventional ranges is important for obtaining the isolated saponins. This can be illustrated in the context of solid phase extraction of saponins from iscom matrix particles using solid phase extraction cartridges as follows. The mass of the iscom matrix particles in a sample can be defined as the saponin concentration in mg. The iscom matrix particles also comprise phospholipids and cholesterol. The loading can correspond, for example, to approximately 0.5 mg saponin per 500 mg bed-weight of sorbent (approx. 0.1% of the bed-weight). In contrast, a general recommendation from manufacturers of solid phase extraction cartridges would be 25-100 mg sample per 500 mg bed-weight (approx. 5% of the bed-weight). The reason to use relatively low loading is due to solubility considerations, and the need to disintegrate the iscom matrix particles, in addition to the overall loading capacity of the solid phase extraction sorbent. Considering solubility reasons first, saponins, phosphatidylcholine, and/or cholesterol may have limited solubility in methanol and methanol:water (5:95 (V:V)) eluents. This is so even though these eluents have been determined herein to result in maximum saponin recovery and repeatability and complete retention of phosphatidylcholine and cholesterol on the sorbent. Turning to the need to disintegrate the iscom matrix particles, the iscom matrix particles must be disintegrated in the initial part of the stationary phase prior to separation of saponin from the lipids. Methanol is effective for this. Considering overall loading capacity of the solid phase extraction sorbent, this is dependent on the total loading from all sample components including the saponins (0.5 mg), the lipids (approximately 0.5 mg) and PBS buffer (approximately 1 mg salts). Advantageously, it has been determined herein that a sample amount of 0.5 mg is enough for precise quantitative proton NMR measurements.

The method also comprises a step of (2) lyophilizing the isolated saponins, thereby obtaining lyophilized saponins.

The method also comprises a step of (3) preparing a solution of the lyophilized saponins and a predetermined amount of an internal standard compound that comprises one or more protons in deuterated methanol. The internal standard compound can comprise, for example, maleic acid, and the one or more protons of the internal standard compound can comprise, for example, the two magnetically equivalent olefinic protons of the maleic acid. Alternatively, other suitable internal standard compounds, also including one or more protons, can be used. The solution can be prepared, for example, by pre-dissolving the internal standard compound in deuterium oxide, then combining the pre-dissolved internal standard compound, the lyophilized saponins, and deuterated methanol to obtain the solution. Alternatively, other suitable approaches for making the solution can be used.

The method also comprises a step of (4) generating a quantitative proton NMR spectrum of the solution of the lyophilized saponins and the internal standard compound including a signal for the three protons of the C26 methyl group of the triterpene core of the saponins and a signal for the one or more protons of the internal standard compound.

In some embodiments, the quantitative proton NMR spectrum is generated according to the following parameters: (a) a pulse flip angle of 30°; (b) a relaxation delay of at least 10 seconds; and (c) an acquisition time of at least 2.7 seconds. Based on the structures of typical saponins and the results provided below, these parameters would be expected to be suitable.

In some of these embodiments, the quantitative proton NMR spectrum is further generated according to one or more of the following parameters: (d) a temperature of 12-30 °C; (e) a field strength of at least 400 MHz or at least 600 MHz; (f) a probe with proton channel having a probe diameter of 1 mm to 10 mm, for example 5 mm; (g) at least 64 scans or at least 128 scans or at least 256 scans; (h) a sweep width of at least 12 ppm or at least 16 ppm; or (i) line broadening function of at least 0.3 Hz or 1 Hz. Based on the structures of typical saponins and the results provided below, these parameters also would be expected to be suitable.

The method also comprises a step of (5) comparing the signal for the three protons of the C26 methyl group of the triterpene core of the saponins and the signal for the one or more protons of the internal standard compound. The comparison of NMR signals can be, for example, comparison of integrals of peaks. This is a standard approach and is good for accuracy. The comparison of NMR signals also can be, for example, comparison of intensities of peaks, e.g., comparison of peak heights, but this generally is not as accurate, particularly for signals that include multiple peaks. The comparison of NMR signals can be carried out, for example, as discussed in the Experimental Section below.

In some embodiments, step (5) comprises manual phase correction, automatic polynomial baseline correction, calibration of chemical shift scale, manual polynomial baseline correction, and integration of signals of the quantitative proton NMR spectrum.

Considering the saponins in more detail, in some of these embodiments the triterpene core of one or more of the saponins further comprises a C23 aldehyde group. Also in some of these embodiments, the calibration of chemical shift scale comprises setting a main peak of the C23 aldehyde group to 9.45 ppm.

In some embodiments, (i) the manual polynomial baseline correction comprises correcting the signal for the three protons of the C26 methyl group of the triterpene core of the saponins at a chemical shift range of 0.60 to 0.85 ppm; and/or (ii) the integration of signals comprises applying integration limits for the signal for the three protons of the C26 methyl group of the triterpene core of the saponins based on a chemical shift range of 0.73 to 0.85 ppm.

In some embodiments, step (5) comprises conducting area normalization of the signal for the three protons of the C26 methyl group of the triterpene core of the saponins and the signal for the one or more protons of the internal standard compound to account for differences in numbers of magnetically equivalent protons thereof.

Again considering the saponins in more detail, in some embodiments the triterpene core of the saponins further comprises a C3 position and a C28 position, and the saponins further comprise a di-saccharide group or a tri-saccharide group attached to the C3 position of the triterpene core, and an oligosaccharide group attached to the C28 position of the triterpene core.

In some of these embodiments, the triterpene core comprises one or more of a Quillaic acid triterpene core, a Quillaic acid 22β-OH triterpene core, a Phytolaccagenic acid triterpene core, a Phytolaccagenic acid 23-OAc triterpene core, a Gypsogenin triterpene core, or an Echinocystic acid triterpene core. As noted above, these are saponin triterpene cores that include a C26 methyl group, a C3 position, and a C28 position.

Also in some of these embodiments, the oligosaccharide group comprises a fucosyl group comprising an O-3 position and an O-4 position. Also in some of these embodiments, one or more of the saponins further comprise a fatty acyl group and/or an acyl II group attached to the O-3 position or the O-4 position of the fucosyl group. In some of these embodiments the proton NMR spectrum of the solution of the lyophilized saponins and the internal standard further includes a signal for one or more protons of the fatty acyl group attached to the O-3 position or the O-4 position of the fucosyl group, and the method further comprises a step (6) of comparing the signal for the one or more protons of the fatty acyl group attached to the O-3 position or the O-4 position of the fucosyl group to one or more of the signal for the three protons of the C26 methyl group of the triterpene core of the saponins or the signal for the one or more protons of the internal standard compound.

According to these embodiments, the degree of fatty acylation of the saponins can be determined as the percentage of Fatty acyl and/or Acyl II groups linked to O-4 or O-3 of the fucosyl residue per triterpene residue. Alternatively or additionally, the degree of fatty acylation of the saponins can be determined as the percentage of Fatty acyl and/or Acyl II groups linked to O-4 or O-3 of the fucosyl residue per the internal standard compound. Again, the comparison of NMR signals can be, for example, comparison of integrals of peaks or comparison of intensities of peaks. Also, the comparison of NMR signals can be carried out, for example, as discussed in the Experimental Section below.

### EXAMPLES

### 1. Purpose

A procedure for determination of the saponin content in iscom matrix particles and characterization of saponin from iscom matrix particles by proton NMR spectroscopy (1H-NMR) is described.

### 2. Scope

The scope includes (1) providing iscom matrix particle samples that contain various saponins from *Quillaja saponaria* Molina and/or modified saponins from *Quillaja saponaria* Molina, (2) solid phase extraction (SPE) for sample pre-treatment, and (3) proton NMR spectroscopy as an analytical methodology.

### 3. Introduction

Applying qNMR to disintegrated iscom matrix particles enables determination of the saponin content as well as measurement of the relative proportions of key structural features in the material, such as the triterpene fatty acyl groups.

### 4. Experimental

The procedure of quantitative NMR analysis involves a sample workup step for iscom matrix particle samples to avoid signal overlap between the phospholipids and cholesterol of the samples and the saponins of the samples and thereby enable quantification. Supelco Discovery DSC-18 SPE tubes, with a bed weight of 500 mg/3 mL tube, are used according to the following steps:
1. Conditioning by adding 1000 µL of methanol.
2. Equilibrating by adding 1000 µL of 5:95 (V:V) methanol:water solution.
3. Sample loading, adding approximately 0.5 mg of total saponin content, assuming 100% conversion of saponins into iscom matrix particles in the iscom matrix particle formation.
4. Wash with 1000 µL of 5:95 (V:V) methanol:water solution, then elute column to dryness.
5. Elute analyte by adding 1000 µL of methanol, then elute column to dryness.
6. Add 100 µl water to sample prior to evaporation, final water content should be approximately 10% (V:V).
7. Evaporate the sample by centrifugal evaporation at 40 °C and 2000 RPM. 1.5 mL evaporates in approximately 6 hours.

Maleic acid of certified purity is used as an internal standard. A stock solution is prepared by adding 4-6 mg of maleic acid to 6 g of deuterated water (99.9% isotopic purity or higher). 50.0 µL of the stock solution is weighted into each lyophilized sample.

The sample containing saponins and internal standard are then reconstituted in 0.57 mL of deuterated methanol.

1H-NMR spectra are recorded at 12° C on a Bruker 600 MHz spectrometer using a 5 mm broadband probe. For quantitative 1H-NMR measurements, a standard proton experiment (zg30), a pulse flip angle of 30°, with 128 or 256 scans, a relaxation delay (D1) of 30 s, a sweep width of 20 ppm and an acquisition time (AQ) of 2.7 s are applied. This setup allows for a total of 32.7 s of spin relaxation between scans to avoid spin saturation. Prior to Fourier transformation a window function was applied with a line broadening function of 1 Hz. The chemical shift scale is calibrated by setting the main peak of the aldehyde signal to 9.45 ppm. After manual phasing and polynomial baseline correction (A+Bx+Cx²), the integration of the signals can be applied.

Settings for each of the parameters that are defined in this section may all slightly influence the NMR spectrum with respect to peak position, peak splitting and/or peak amplitude. Reasonably acceptable settings and/or ranges are as follows: temperature 12-30 deg C, field strength 600 MHz or higher (lower field strengths will increase peak overlap; undesirable), any 5 mm probe with proton channel and equal or better sensitivity, any single pulse experiment for proton detection (e.g., zg30), a pulse flip angle of 30° (sensitivity and response optimized at this setting), 128 or 256 scans (or fewer scans if a more sensitive instrument/probe is used), a relaxation delay of 30 s or more (tested and optimized for saponin/maleic acid (standard) combination, reasonably 10 s or longer is justified according to ongoing work), sweep width of at least 16 ppm, AQ = 2.7 s or longer (enough digital resolution required for reliable peak integration), line broadening function of 1 Hz (optimized to 1 Hz for optimum resolution and sensitivity on our system).

### 4.1. Characterization by measurement of ratios of key structural features

Application of quantitative NMR to disintegrated iscom matrix particles enables measurement of the ratio of key structural features in the material, such as aldehyde and fatty acyl groups.

The degree of fatty acylation can be determined by comparing the signals Fa-2 and Fa-2' to Sap26 (shown in FIG. 1 and FIG. 2). Signals Fa-2 and Fa-2' originate from two geminal proton pairs present for Fatty acyl and Acyl II groups. The Acyl I group would result in a signal that overlaps with Fa-2'. The degree of fatty acylation is intended to be evaluated for samples that mainly comprise Fatty acyl and Acyl II, i.e., saponin type II or saponin type III samples. Methyl signal Sap26 is common to all triterpenes such as Quillaic acid, Quillaic acid 22β-OH, Phytolaccagenic acid, Phytolaccagenic acid 23-OAc, Gypsogenin and Echinocystic acid, which are reported triterpenes from the tree *Quillaja saponaria* Molina (Fleck et al., Molecules 2019, 24(1), 171; doi.org/10.3390/molecules24010171, and references therein). The Sap26 peak is composed of three magnetically equivalent protons. Signal Sap26 can be used as a reference, since it is common for most *Quillaja saponaria* related triterpenes and the fact that different substitution patterns (e.g. sugars or acyl groups) do not alter its position (chemical shift) in the spectrum. The degree of fatty acylation, given in Equation 1, reports the percentage of fatty acyl substituted saponins in the saponin material or iscom matrix particles. The maximum theoretical value is 100%. The sum of signal integrals is divided by the total number of protons (n=4) in the combined signals. $Degree of Fatty Acylation \left(%\right) = 100 \times \frac{\frac{\left(Fa-2+Fa-2′\right)}{4}}{\left(\frac{Sap 26}{3}\right)}$ Equation 1.

The degree of fatty acylation may be used, for example, for characterizing the composition of naturally occurring or modified saponin samples or to study degradation of saponin samples over time. Equation 1 is strictly applicable for saponin type II and/or III samples that comprise Fatty acyl and/or Acyl II. Samples that comprise mainly Acyl I may be evaluated by Equation 1, but the total number of protons may be adjusted to (n=1) in order to obtain a more realistic degree of acylation.

### 4.2. Determination of saponin content

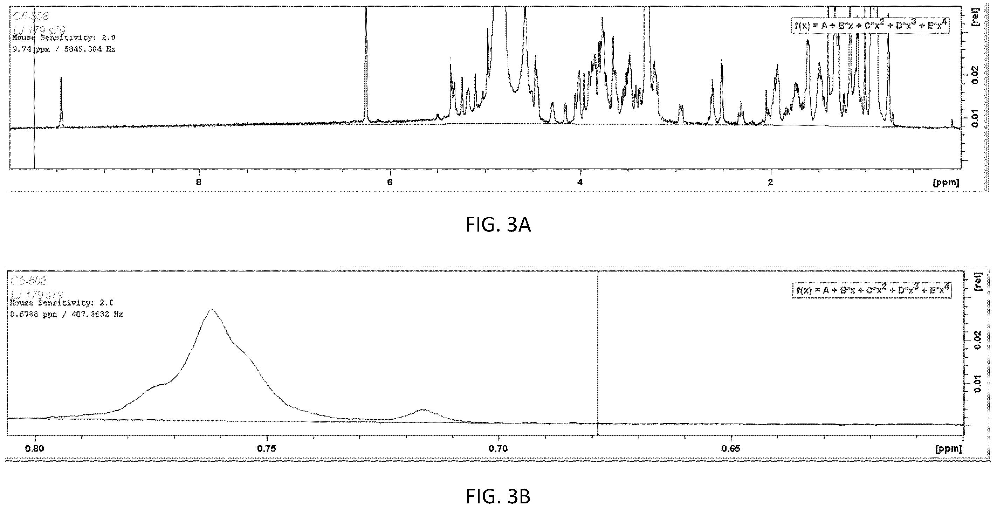

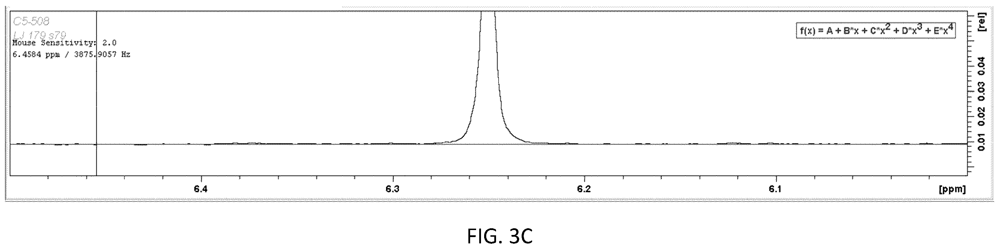

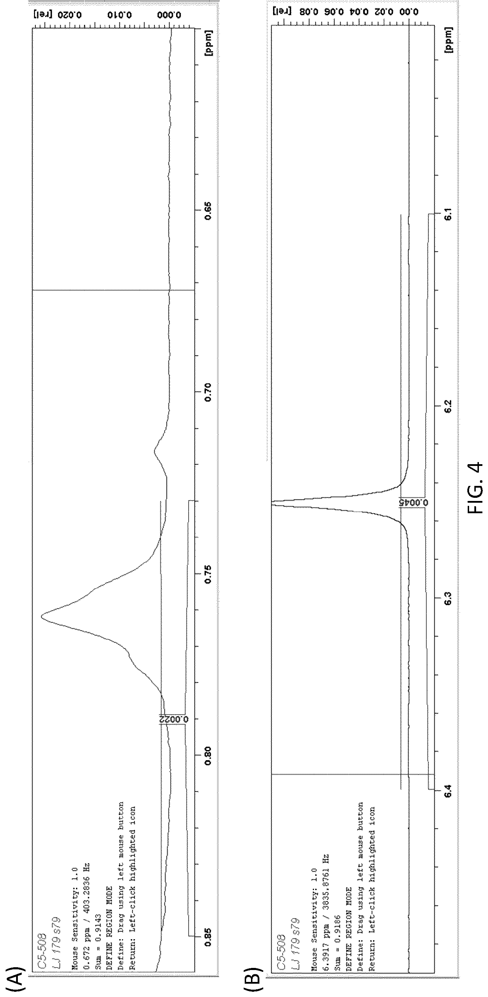

Quantitative 1H-NMR spectroscopy is suitable for determination of the saponin content in disintegrated iscom matrix particles. After manual phase correction followed by polynomial baseline correction (A+Bx+Cx²) as described above, further manual baseline correction is performed according to TABLE 2 and FIGS. 3A-C, and integration of signals is carried out manually according to TABLE 3 and FIG. 4.

**TABLE 2. Baseline correction ranges for determination of saponin content in a sample of disintegrated iscom matrix particles.**

| **Signal** | **Chemical shift (ppm)** | **Number of protons** | **Tentative range (ppm)** |
|---|---|---|---|
| Sap26 | 0.76-0.80 | 3 | 0.60-0.85 |
| Maleic acid | 6.25 | 2 | 5.9-6.5 |

**TABLE 3. Integration limits for determination of saponin content.**

| **Signal** | **Chemical shift (ppm)** | **Number of protons** | **Tentative range (ppm)** |
|---|---|---|---|
| Sap26 | 0.76-0.80 | 3 | 0.73-0.85 |
| Maleic acid | 6.25 | 2 | 6.1-6.4 |

Area normalization is required since the Sap26 peak is composed of three magnetically equivalent protons and the maleic acid peak is composed of two magnetically equivalent protons. The molar ratio between the saponin and maleic acid can be determined directly from the normalized areas (integrals) of the saponin and maleic acid peaks by the formula given in Equation 2. $molar ratio = \frac{Mol \left(sap\right)}{Mol \left(ma\right)} = \frac{Integral saponin}{Integral maleic acid} \times \frac{2}{3}$ Equation 2.

This means that the relation between the normalized peak integrals is directly proportional to the molar ratio. Further equations can be used to obtain the saponin content as follows below.

The molar concentration, C(ma), of the maleic acid stock solution is calculated by the formula in Equation 3. $\begin{matrix}C \left(ma, stock\right) = Purity \left(ma\right) \times \frac{Mol \left(ma\right)}{Volume \left(D2O\right)} \times {10}^{6} \\ = Purity \left(ma\right) \times \frac{\left(\frac{Weight \left(ma\right)}{MW \left(ma\right)}\right)}{\left(\frac{Weight \left(D2O\right)}{Density \left(D2O\right)}\right)} \times {10}^{6}\end{matrix}$ Equation 3.

C(ma) is expressed in mmol/L. Weight(ma) and Weight(D2O), both in mg, are recorded during the preparation of the maleic acid stock solution. Purity(ma) is the certified purity (weight/weight) of maleic acid. MW(ma) is the molecular weight of maleic acid (116.1 g/mol). Density(D2O) is the density of deuterium oxide at room temperature (1.156 g/mL). A conversion factor 10⁶ is introduced to obtain the resulting molar concentration in mmol/L.

The molar amount of maleic acid in the NMR sample, Mol(ma), is calculated by the formula in Equation 4. $Mol \left(ma\right) = C \left(ma, stock\right) \times Volume \left(ma\right)$ Eqution 4.

Volume(ma) is the volume of maleic acid stock solution that was added to the NMR sample (50.0 microliters).

The molar amount of saponin, Mol(sap), in the NMR sample can be calculated by the formula given in Equation 5. $Mol \left(sap\right) = Mol \left(ma\right) \times \frac{Integral saponin}{Integral maleic acid} \times \frac{2}{3}$ Equation 5.

The molar concentration of saponin, *C(sap),* in the NMR sample can be calculated by the formula given in Equation 6, which is a combination of Equations 4 and 5. $C \left(sap\right) = C \left(ma\right) \times Volume \left(ma\right) \times \frac{Integral saponin}{Integral maleic acid} \times \frac{2}{3}$ Equation 6.

Finally, the Saponin content of Matrix in mmol/L can be calculated by the formula given in Equation 7. $Saponin content = C \left(ma\right) \times Volume \left(ma\right) \times \frac{Integral saponin}{Integral maleic acid} \times \frac{2}{3} \times \frac{1}{Volume \left(sap\right)}$ Equation 7.

In Equation 7, C(ma) (in mmol/L) is obtained from Equation 3 and the remaining variables are obtained from the sample preparation procedure and the NMR spectrum. Volume(sap) is the volume of the iscom matrix particles dispersion that was loaded on the SPE column at sample workup.

### 5. Results

### 5.1. Sample preparation by SPE - Level of purification and recovery

SPE (solid phase extraction) was applied to remove non-saponin lipid components and salts from the sample before determination of the saponin content by quantitative NMR spectroscopy.

The SPE step was evaluated on a sample of iscom matrix particles designated Matrix type III. The collected fraction after the SPE step was analyzed for saponin and lipid (phosphatidylcholine and cholesterol) by high performance liquid chromatography (HPLC) methods. The recovery of each component was calculated, and the results are compiled in TABLE 4.

**TABLE 4. Recovery of Matrix components.**

| **Sample** | **Saponin type I** | **Saponin type II** | **Cholesterol** | **Phospholipid** |
|---|---|---|---|---|
| Matrix type III | 86.9% | 96.1% | 0.4% | 0% |

The results were found satisfactory and showed that both the level of purification and the recovery of saponin were suitable. The relative standard deviation (RSD) from 6 replicate samples was 1% for both saponin types, which indicates excellent repeatability.

### 5.2. Saponin content in Matrix

The saponin content was determined in two samples of iscom matrix particles, the first designated Matrix type I and the second designated Matrix type II. Three replicates were prepared from each sample. The saponin content was determined and the results are shown in TABLE 5.

**TABLE 5. Saponin contents for Matrix samples.**

| **Matrix Sample** | **#1 (mmol/L)** | **#2 (mmol/L)** | **#3 (mmol/L)** | **Saponin content (mmol/L)** | **Relative standard deviation** |
|---|---|---|---|---|---|
| Matrix type I | 1.897 | 1.811 | 1.856 | 1.855 | 2.3% |
| Matrix type II | 1.399 | 1.434 | 1.394 | 1.409 | 1.6% |

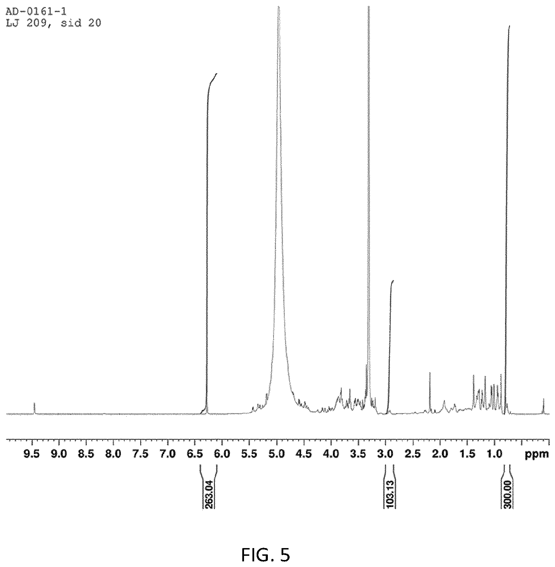

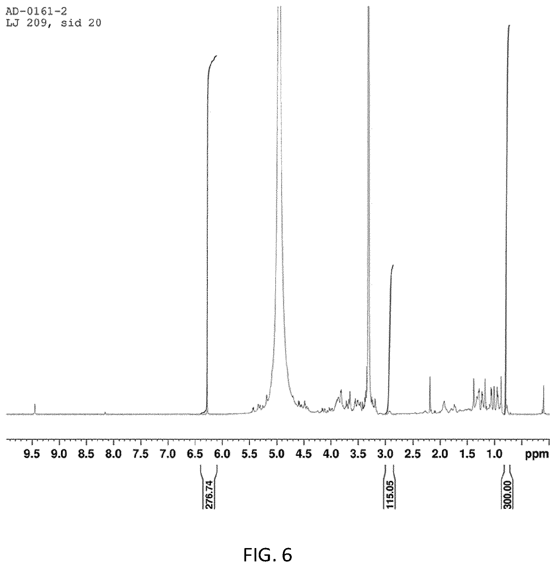

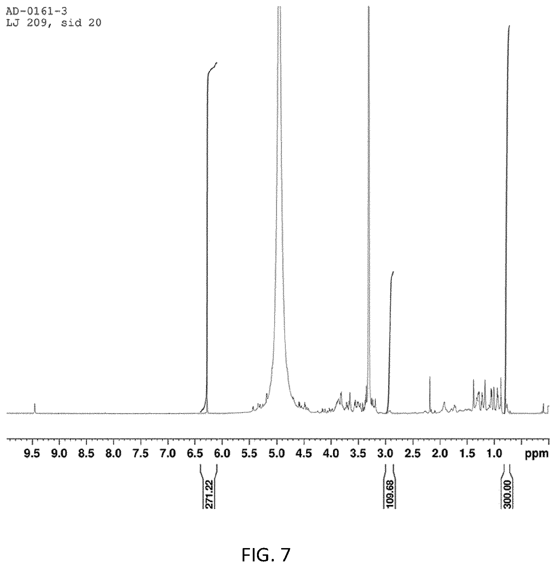

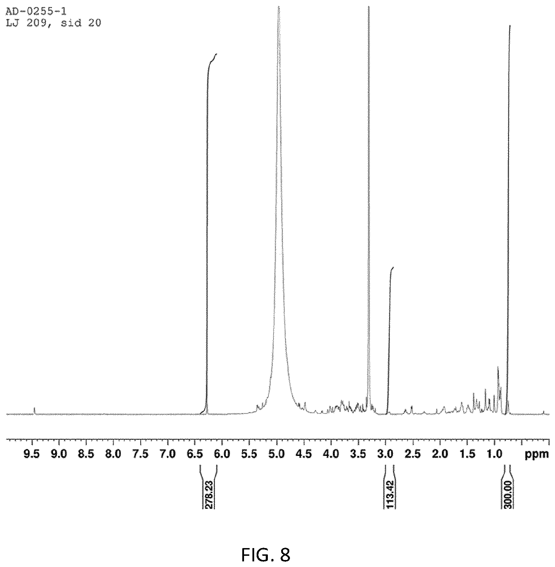

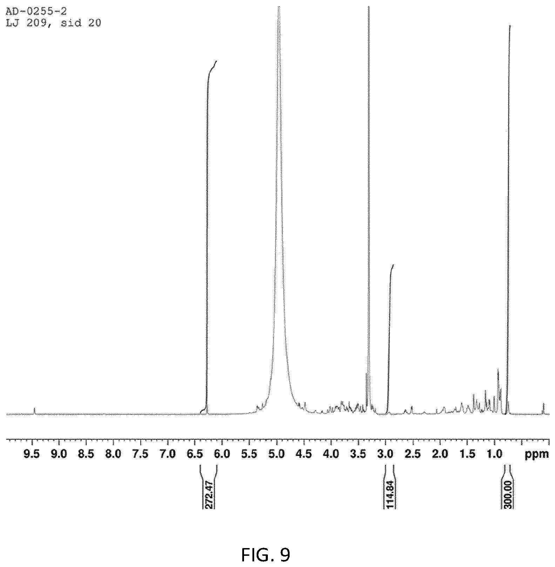

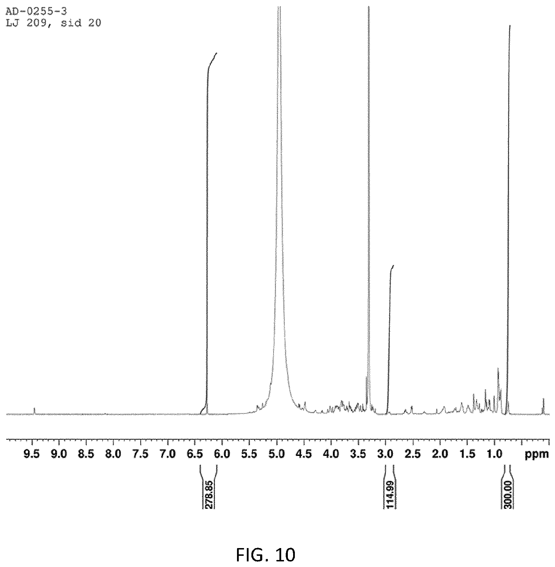

The precision of the method was observed to be approximately 2%. The corresponding NMR spectra are shown in FIGS. 5-10.

### 5.3 Saponin content in modified Matrix (deacylated)

Saponin contents were determined for samples of deacylated iscom matrix particles. Two replicates were prepared for most samples. Saponin contents also were determined for reference samples. Results as shown in TABLE 6.

**TABLE 6. Saponin content by NMR (mmol/L) for modified Matrix (deacylated) and reference Matrix samples.**

| **Sample** | **Replicate** | **Saponin content (NMR)** | **Average** | **RSD** |
|---|---|---|---|---|
| #1 Matrix on deacylated Saponin type II | N/A | 0.261 mmol/L | N/A | N/A |
| #2 Matrix on deacylated:unmodified 50:50 saponin | N/A | 0.709 mmol/L | N/A | N/A |
| #3 Matrix on unmodified Saponin type II | N/A | 0.623 mmol/L | N/A | N/A |
| #4 Matrix type II ref. | 1 | 1.931 mmol/L | 1.97 mmol/L | 2% |
| #4 Matrix type II ref. | 2 | 2.002 mmol/L | | |
| #5 Matrix type II ref. | 1 | 1.587 mmol/L | 1.62 mmol/L | 2% |
| #5 Matrix type II ref. | 2 | 1.646 mmol/L | | |
| #6 Matrix type II ref. | 1 | 1.654 mmol/L | 1.62 mmol/L | 2% |
| #6 Matrix type II ref. | 2 | 1.594 mmol/L | | |
| #7 Matrix type II ref. | 1 | 2.151 mmol/L | 2.10 mmol/L | 2% |
| #7 Matrix type II ref. | 2 | 2.050 mmol/L | | |

Additional results for saponin contents are provided in TABLE 7.

**TABLE 7. Saponin content by NMR (mmol/L) for additional samples.**

| **Sample** | **Replicate** | **Saponin content (mmol/L)** | **Average (mmol/L)** | **RSD** |
|---|---|---|---|---|
| #8 Matrix type II on unmodified Saponin type II | 1 | 0.530 | 0.529 | 0% |
| #8 Matrix type II on unmodified Saponin type II | 2 | 0.528 | | |
| #9 Matrix on deacylated:unmodified 50:50 saponin | 1 | 0.649 | 0.665 | 3% |
| #9 Matrix on deacylated:unmodified 50:50 saponin | 2 | 0.680 | | |
| #10 Matrix on deacylated:unmodified 60:40 saponin | 1 | 0.672 | 0.685 | 3% |
| #10 Matrix on deacylated:unmodified 60:40 saponin | 2 | 0.699 | | |
| #11 Matrix on deacylated Saponin type II | 1 | 0.205 | 0.217 | 8% |
| #11 Matrix on deacylated Saponin type II | 2 | 0.228 | | |
| #12 Matrix on deacylated Saponin type II | 1 | 0.509 | 0.500 | 3% |
| #12 Matrix on deacylated Saponin type II | 2 | 0.490 | | |
| #13 Matrix on deacylated Saponin type II | 1 | 0.366 | 0.367 | 0% |
| #13 Matrix on deacylated Saponin type II | 2 | 0.367 | | |
| #14 Matrix on deacylated Saponin type II | 1 | 0.464 | 0.456 | 3% |
| #14 Matrix on deacylated Saponin type II | 2 | 0.447 | | |
| #15 Matrix type I ref. | 1 | 1.842 | 1.898 | 4% |
| #15 Matrix type I ref. | 2 | 1.954 | | |
| #16 Matrix type II ref. | 1 | 1.514 | 1.558 | 4% |
| #16 Matrix type II ref. | 2 | 1.601 | | |

### 5.4. Degree of fatty acylation in Matrix and degraded samples

The degree of fatty acylation was determined for various samples of degraded iscom matrix particles and reference iscom matrix particles samples, all disintegrated prior to determination of fatty acylation as described above. Results are shown in TABLE 8.

**TABLE 8. Degree of fatty acylation for degraded and reference disintegrated iscom matrix particles samples.**

| **Sample ID** | **Condition** | **Fatty acylation signal (%)** |
|---|---|---|
| #17 | Unstressed Matrix type II (reference) | 94 |
| #18 | Unstressed Matrix type III (reference) | 15 |
| #19 | Matrix type II low pH 2 weeks | 66 |
| #20 | Matrix type II high pH 48 hours | 27 |
| #21 | Matrix type III low pH 2 weeks | 10 |
| #22 | Matrix type III high pH 48 hours | 4 |
| #23 | Matrix type II 25°C 2 weeks | 91 |
| #24 | Matrix type III 25°C 2 weeks | 14 |

In TABLE 8, unstressed Matrix refers to conventional disintegrated reference samples.

The degree of fatty acylation also was determined for samples of deacylated iscom matrix particles and reference disintegrated iscom matrix samples. Results are shown in TABLE 9.

**TABLE 9. Degree of fatty acylation for deacylated and reference disintegrated iscom matrix samples.**

| **Sample** | **Fatty acylation signal (%)** |
|---|---|
| Matrix type II | 95 |
| Matrix type II "50/50" | 38 |
| Matrix prepared from deacylated saponin | 0 |

## Claims

1. A method of quantifying saponins present in particles comprising saponin and lipid, wherein the saponins of the particles comprise a triterpene core comprising a C26 methyl group comprising three protons, the method comprising steps of:
(1) isolating the saponins from the lipids of the particles comprising saponin and lipid by reversed phase solid phase extraction of the saponins from a predetermined amount of the particles comprising saponin and lipid, thereby obtaining isolated saponins;
(2) lyophilizing the isolated saponins, thereby obtaining lyophilized saponins;
(3) preparing a solution of the lyophilized saponins and a predetermined amount of an internal standard compound that comprises one or more protons in deuterated methanol;
(4) generating a quantitative proton NMR spectrum of the solution of the lyophilized saponins and the internal standard compound including a signal for the three protons of the C26 methyl group of the triterpene core of the saponins and a signal for the one or more protons of the internal standard compound; and
(5) comparing the signal for the three protons of the C26 methyl group of the triterpene core of the saponins and the signal for the one or more protons of the internal standard compound.

2. The method according to claim 1, wherein step (1) comprises steps of:
(1.1) conditioning a reversed phase solid phase extraction sorbent with a polar organic solvent;
(1.2) equilibrating the reversed phase solid phase extraction sorbent with a mixture comprising the polar organic solvent and water;
(1.3) loading the particles comprising saponin and lipid onto the reversed phase solid phase extraction sorbent;
(1.4) washing the reversed phase solid phase extraction sorbent with a mixture comprising the polar organic solvent and water; and
(1.5) eluting the saponins from the reversed phase solid phase extraction sorbent with the polar organic solvent, thereby obtaining the isolated saponins in a mixture comprising the isolated saponins and the polar organic solvent.

3. The method according to claim 2, wherein the polar organic solvent comprises methanol.

4. The method according to claim 3, wherein the mixtures comprising the polar organic solvent and water in one or more of the steps (1.2) or (1.4) comprise methanol and water at a ratio of 1:99 to 20:80 (V:V), 2:98 to 10:90 (V:V), 3:97 to 7:93 (V:V), or about 5:95 (V:V).

5. The method according to any one of claims 2-4, wherein during step (1.3) the particles comprising saponin and lipid are loaded onto the reversed phase solid phase extraction sorbent at 0.1 mg to 2 mg saponin content, 0.2 mg to 1 mg saponin content, 0.3 mg to 0.7 mg saponin content, 0.4 mg to 0.6 mg saponin content, or about 0.5 mg saponin content, per 500 mg bed weight of the reversed phase solid phase extraction sorbent.

6. The method according to any one of claims 2-5, wherein the reversed phase solid phase extraction sorbent comprises an octadecyl sorbent active group.

7. The method according to any one of claims 2-6, wherein step (1) further comprises a step (1.6) of adding water to the mixture comprising the isolated saponins and the polar organic solvent to a final water content of 5% to 20%, 7% to 15%, 9% to 12%, or about 10%, by volume.

8. The method according to any one of claims 1-7, wherein the predetermined amount of the particles comprising saponin and lipid is a saponin content of a formulation used to make the particles comprising saponin and lipid.

9. The method according to any one of claims 1-8, wherein the internal standard compound comprises maleic acid and the one or more protons of the internal standard compound comprise two magnetically equivalent olefinic protons of the maleic acid.

10. The method according to any one of claims 1-9, wherein the quantitative proton NMR spectrum is generated according to the following parameters:
(a) a pulse flip angle of 30°;
(b) a relaxation delay of at least 10 seconds; and
(c) an acquisition time of at least 2.7 seconds.

11. The method according to claim 10, wherein the quantitative proton NMR spectrum is further generated according to one or more of the following parameters:
(d) a temperature of 12-30 °C;
(e) a field strength of at least 400 MHz or at least 600 MHz;
(f) a probe with proton channel having a probe diameter of 1 mm to 10 mm, for example 5 mm;
(g) at least 64 scans or at least 128 scans or at least 256 scans;
(h) a sweep width of at least 12 ppm or at least 16 ppm; or
(i) line broadening function of at least 0.3 Hz or 1 Hz.

12. The method according to any one of claims 1-11, wherein step (5) comprises manual phase correction, automatic polynomial baseline correction, calibration of chemical shift scale, manual polynomial baseline correction, and integration of signals of the quantitative proton NMR spectrum.

13. The method according to claim 12, wherein the triterpene core of one or more of the saponins further comprises a C23 aldehyde group.

14. The method according to claim 13, wherein the calibration of chemical shift scale comprises setting a main peak of the C23 aldehyde group to 9.45 ppm.

15. The method according to any of claims 12-14, wherein:
(i) the manual polynomial baseline correction comprises correcting the signal for the three protons of the C26 methyl group of the triterpene core of the saponins at a chemical shift range of 0.60 to 0.85 ppm; and/or
(ii) the integration of signals comprises applying integration limits for the signal for the three protons of the C26 methyl group of the triterpene core of the saponins based on a chemical shift range of 0.73 to 0.85 ppm.

16. The method according to any one of claims 1-15, wherein step (5) comprises conducting area normalization of the signal for the three protons of the C26 methyl group of the triterpene core of the saponins and the signal for the one or more protons of the internal standard compound to account for differences in numbers of magnetically equivalent protons thereof.

17. The method according to any one of claims 1-16, wherein the triterpene core of the saponins further comprises a C3 position and a C28 position, and the saponins further comprise a di-saccharide group or a tri-saccharide group attached to the C3 position of the triterpene core, and an oligosaccharide group attached to the C28 position of the triterpene core.

18. The method according to claim 17, wherein the triterpene core comprises one or more of a Quillaic acid triterpene core, a Quillaic acid 22β-OH triterpene core, a Phytolaccagenic acid triterpene core, a Phytolaccagenic acid 23-OAc triterpene core, a Gypsogenin triterpene core, or an Echinocystic acid triterpene core.

19. The method according to claim 17 or claim 18, wherein the oligosaccharide group comprises a fucosyl group comprising an O-3 position and an O-4 position.

20. The method according to claim 19, wherein one or more of the saponins further comprise a fatty acyl group and/or an acyl II group attached to the O-3 position or the O-4 position of the fucosyl group.

21. The method according to claim 20, wherein the proton NMR spectrum of the solution of the lyophilized saponins and the internal standard further includes a signal for one or more protons of the fatty acyl group attached to the O-3 position or the O-4 position of the fucosyl group, and the method further comprises a step (6) of comparing the signal for the one or more protons of the fatty acyl group attached to the O-3 position or the O-4 position of the fucosyl group to one or more of the signal for the three protons of the C26 methyl group of the triterpene core of the saponins or the signal for the one or more protons of the internal standard compound.

22. The method according to any one of claims 1-21, wherein the saponins comprise saponins extracted from bark of the South American soapbark tree *Quillaja saponaria* Molina.

23. The method according to any one of claims 1-22, wherein the particles comprising saponin and lipid comprise or consist of one or more of iscom matrix particles, iscom antigen-presenting particles, liposome-based Adjuvant System 01 particles, or Army Liposome Formulation Q particles.

24. The method according to any one of claims 1-23, wherein the lipids comprise one or more phospholipids and cholesterol.

25. The method according to claim 24, wherein the one or more phospholipids comprise one or more phosphatidylcholines.

26. The method according to any one of claims 23-25, wherein the particles comprising saponin and lipid are iscom matrix particles that consist essentially of the saponins, the one or more phospholipids, and the cholesterol.

27. The method according to any one of claims 23-25, wherein the particles comprising saponin and lipid are iscom antigen-presenting particles that consist essentially of the saponins, the one or more phospholipids, the cholesterol, and one or more antigens.

## Patentansprüche

1. Verfahren zum Quantifizieren von Saponinen, die in Saponin und Lipid umfassenden Partikeln vorliegen, wobei die Saponine der Partikel einen Triterpenkern umfassen, der eine drei Protonen umfassende C26-Methylgruppe umfasst, wobei das Verfahren die folgenden Schritte umfasst:
(1) Isolieren der Saponine von den Lipiden der Saponin und Lipid umfassenden Partikel durch Umkehrphasen-Festphasenextraktion der Saponine aus einer vorbestimmten Menge der Saponin und Lipid umfassenden Partikel, wodurch isolierte Saponine erhalten werden;
(2) Lyophilisieren der isolierten Saponine, wodurch lyophilisierte Saponine erhalten werden;
(3) Herstellen einer Lösung der lyophilisierten Saponine und einer vorbestimmten Menge einer internen Standardverbindung, die ein oder mehrere Protonen umfasst, in deuteriertem Methanol;
(4) Erzeugen eines quantitativen Protonen-NMR-Spektrums der Lösung der lyophilisierten Saponine und der internen Standardverbindung, das ein Signal für die drei Protonen der C26-Methylgruppe des Triterpenkerns der Saponine und ein Signal für das eine oder die mehreren Protonen der internen Standardverbindung einschließt; und
(5) Vergleichen des Signals für die drei Protonen der C26-Methylgruppe des Triterpenkerns der Saponine und des Signals für das eine oder die mehreren Protonen der internen Standardverbindung.

2. Verfahren nach Anspruch 1, wobei Schritt (1) die folgenden Schritte umfasst:
(1.1) Konditionieren eines Umkehrphasen-Festphasenextraktionssorbens mit einem polaren organischen Lösungsmittel;
(1.2) Äquilibrieren des Umkehrphasen-Festphasenextraktionssorbens mit einer Mischung, die das polare organische Lösungsmittel und Wasser umfasst;
(1.3) Aufbringen der Saponin und Lipid umfassenden Partikel auf das Umkehrphasen-Festphasenextraktionssorbens;
(1.4) Waschen des Umkehrphasen-Festphasenextraktionssorbens mit einer Mischung, die das polare organische Lösungsmittel und Wasser umfasst; und
(1.5) Eluieren der Saponine von dem Umkehrphasen-Festphasenextraktionssorbens mit dem polaren organischen Lösungsmittel, wodurch die isolierten Saponine in einer Mischung erhalten werden, die die isolierten Saponine und das polare organische Lösungsmittel umfasst.

3. Verfahren nach Anspruch 2, wobei das polare organische Lösungsmittel Methanol umfasst.

4. Verfahren nach Anspruch 3, wobei die Mischungen, die das polare organische Lösungsmittel und Wasser umfassen, in einem oder mehreren der Schritte (1.2) oder (1.4) Methanol und Wasser in einem Verhältnis von 1:99 bis 20:80 (V:V), 2:98 bis 10:90 (V:V), 3:97 bis 7:93 (V:V) oder etwa 5:95 (V:V) umfassen.

5. Verfahren nach einem der Ansprüche 2 bis 4, wobei während des Schritts (1.3) die Saponin und Lipid umfassenden Partikel mit einem Saponingehalt von 0,1 mg bis 2 mg, einem Saponingehalt von 0,2 mg bis 1 mg, einem Saponingehalt von 0,3 mg bis 0,7 mg, einem Saponingehalt von 0,4 mg bis 0,6 mg oder einem Saponingehalt von etwa 0,5 mg pro 500 mg Bettgewicht des Umkehrphasen-Festphasenextraktionssorbens auf das Umkehrphasen-Festphasenextraktionssorbens aufgebracht werden.

6. Verfahren nach einem der Ansprüche 2 bis 5, wobei das Umkehrphasen-Festphasenextraktionssorbens eine Octadecyl-Sorbens-Aktivgruppe umfasst.

7. Verfahren nach einem der Ansprüche 2 bis 6, wobei Schritt (1) ferner einen Schritt (1.6) des Zugebens von Wasser zu der Mischung, die die isolierten Saponine und das polare organische Lösungsmittel umfasst, auf einen endgültigen Wassergehalt von 5 % bis 20 %, 7 % bis 15 %, 9 % bis 12 % oder etwa 10 %, bezogen auf das Volumen, umfasst.

8. Verfahren nach einem der Ansprüche 1 bis 7, wobei die vorbestimmte Menge der Saponin und Lipid umfassenden Partikel ein Saponingehalt einer Formulierung ist, die zur Herstellung der Saponin und Lipid umfassenden Partikel verwendet wird.

9. Verfahren nach einem der Ansprüche 1 bis 8, wobei die interne Standardverbindung Maleinsäure umfasst und das eine oder die mehreren Protonen der internen Standardverbindung zwei magnetisch äquivalente olefinische Protonen der Maleinsäure umfassen.

10. Verfahren nach einem der Ansprüche 1 bis 9, wobei das quantitative Protonen-NMR-Spektrum gemäß den folgenden Parametern erzeugt wird:
(a) einem Pulsflipwinkel von 30°;
(b) einer Relaxationsverzögerung von mindestens 10 Sekunden; und
(c) einer Akquisitionszeit von mindestens 2,7 Sekunden.

11. Verfahren nach Anspruch 10, wobei das quantitative Protonen-NMR-Spektrum ferner gemäß einem oder mehreren der folgenden Parameter erzeugt wird:
(d) einer Temperatur von 12 bis 30 °C;
(e) einer Feldstärke von mindestens 400 MHz oder mindestens 600 MHz;
(f) einem Probenkopf mit Protonenkanal, der einen Probenkopfdurchmesser von 1 mm bis 10 mm, zum Beispiel 5 mm, aufweist;
(g) mindestens 64 Scans oder mindestens 128 Scans oder mindestens 256 Scans;
(h) einer spektralen Breite von mindestens 12 ppm oder mindestens 16 ppm; oder
(i) Linienverbreiterungsfunktion von mindestens 0,3 Hz oder 1 Hz.

12. Verfahren nach einem der Ansprüche 1 bis 11, wobei Schritt (5) eine manuelle Phasenkorrektur, eine automatische polynomiale Basislinienkorrektur, eine Kalibrierung der Skala der chemischen Verschiebung, eine manuelle polynomiale Basislinienkorrektur und eine Integration von Signalen des quantitativen Protonen-NMR-Spektrums umfasst.

13. Verfahren nach Anspruch 12, wobei der Triterpenkern eines oder mehrerer der Saponine ferner eine C23-Aldehydgruppe umfasst.

14. Verfahren nach Anspruch 13, wobei die Kalibrierung der Skala der chemischen Verschiebung ein Setzen eines Hauptpeaks der C23-Aldehydgruppe auf 9,45 ppm umfasst.

15. Verfahren nach einem der Ansprüche 12 bis 14, wobei:
(i) die manuelle polynomiale Basislinienkorrektur ein Korrigieren des Signals für die drei Protonen der C26-Methylgruppe des Triterpenkerns der Saponine in einem Bereich der chemischen Verschiebung von 0,60 bis 0,85 ppm umfasst; und/oder
(ii) die Integration von Signalen ein Anwenden von Integrationsgrenzen für das Signal für die drei Protonen der C26-Methylgruppe des Triterpenkerns der Saponine auf Grundlage eines Bereichs der chemischen Verschiebung von 0,73 bis 0,85 ppm umfasst.

16. Verfahren nach einem der Ansprüche 1 bis 15, wobei Schritt (5) ein Durchführen einer Flächennormierung des Signals für die drei Protonen der C26-Methylgruppe des Triterpenkerns der Saponine und des Signals für das eine oder die mehreren Protonen der internen Standardverbindung umfasst, um Unterschieden in deren Anzahl magnetisch äquivalenter Protonen Rechnung zu tragen.

17. Verfahren nach einem der Ansprüche 1 bis 16, wobei der Triterpenkern der Saponine ferner eine C3-Position und eine C28-Position umfasst und die Saponine ferner eine Disaccharidgruppe oder eine Trisaccharidgruppe, die an die C3-Position des Triterpenkerns gebunden ist, und eine Oligosaccharidgruppe, die an die C28-Position des Triterpenkerns gebunden ist, umfassen.

18. Verfahren nach Anspruch 17, wobei der Triterpenkern eines oder mehrere von einem Quillajasäure-Triterpenkern, einem Quillajasäure-22β-OH-Triterpenkern, einem Phytolaccagensäure-Triterpenkern, einem Phytolaccagensäure-23-OAc-Triterpenkern, einem Gypsogenin-Triterpenkern oder einem Echinocystsäure-Triterpenkern umfasst.

19. Verfahren nach Anspruch 17 oder Anspruch 18, wobei die Oligosaccharidgruppe eine Fucosylgruppe umfasst, die eine O-3-Position und eine O-4-Position umfasst.

20. Verfahren nach Anspruch 19, wobei eines oder mehrere der Saponine ferner eine Fettacylgruppe und/oder eine Acyl-II-Gruppe umfassen, die an die O-3-Position oder die O-4-Position der Fucosylgruppe gebunden sind.

21. Verfahren nach Anspruch 20, wobei das Protonen-NMR-Spektrum der Lösung der lyophilisierten Saponine und des internen Standards ferner ein Signal für ein oder mehrere Protonen der Fettacylgruppe, die an die O-3-Position oder die O-4-Position der Fucosylgruppe gebunden ist, einschließt und das Verfahren ferner einen Schritt (6) des Vergleichens des Signals für das eine oder die mehreren Protonen der Fettacylgruppe, die an die O-3-Position oder die O-4-Position der Fucosylgruppe gebunden ist, mit einem oder mehreren von dem Signal für die drei Protonen der C26-Methylgruppe des Triterpenkerns der Saponine oder dem Signal für das eine oder die mehreren Protonen der internen Standardverbindung umfasst.

22. Verfahren nach einem der Ansprüche 1 bis 21, wobei die Saponine Saponine umfassen, die aus der Rinde des südamerikanischen Seifenrindenbaums *Quillaja saponaria* Molina extrahiert wurden.

23. Verfahren nach einem der Ansprüche 1 bis 22, wobei die Saponin und Lipid umfassenden Partikel eines oder mehrere von iscom-Matrix-Partikeln, iscom-antigenpräsentierenden Partikeln, liposombasierten Adjuvant-System-01-Partikeln oder Army-Liposome-Formulation-Q-Partikeln umfassen oder daraus bestehen.

24. Verfahren nach einem der Ansprüche 1 bis 23, wobei die Lipide ein oder mehrere Phospholipide und Cholesterin umfassen.

25. Verfahren nach Anspruch 24, wobei das eine oder die mehreren Phospholipide ein oder mehrere Phosphatidylcholine umfassen.

26. Verfahren nach einem der Ansprüche 23 bis 25, wobei die Saponin und Lipid umfassenden Partikel iscom-Matrix-Partikel sind, die im Wesentlichen aus den Saponinen, dem einen oder den mehreren Phospholipiden und dem Cholesterin bestehen.

27. Verfahren nach einem der Ansprüche 23 bis 25, wobei die Saponin und Lipid umfassenden Partikel iscom-antigenpräsentierende Partikel sind, die im Wesentlichen aus den Saponinen, dem einen oder den mehreren Phospholipiden, dem Cholesterin und einem oder mehreren Antigenen bestehen.

## Revendications

1. Procédé de quantification de saponines présentes dans des particules comprenant de la saponine et un lipide, dans lequel les saponines des particules comprennent un noyau triterpénique comprenant un groupe méthyle C26 comprenant trois protons, le procédé comprenant des étapes consistant à :
(1) isoler les saponines des lipides des particules comprenant de la saponine et un lipide par extraction en phase solide à phase inverse des saponines à partir d'une quantité prédéterminée des particules comprenant de la saponine et un lipide, obtenant ainsi des saponines isolées ;
(2) lyophiliser les saponines isolées, obtenant ainsi des saponines lyophilisées ;
(3) préparer une solution des saponines lyophilisées et d'une quantité prédéterminée d'un composé étalon interne qui comprend un ou plusieurs protons dans du méthanol deutéré ;
(4) générer un spectre RMN quantitatif du proton de la solution des saponines lyophilisées et du composé étalon interne, incluant un signal pour les trois protons du groupe méthyle C26 du noyau triterpénique des saponines et un signal pour le ou les protons du composé étalon interne ; et
(5) comparer le signal pour les trois protons du groupe méthyle C26 du noyau triterpénique des saponines et le signal pour le ou les protons du composé étalon interne.

2. Procédé selon la revendication 1, dans lequel l'étape (1) comprend des étapes consistant à :
(1.1) conditionner un sorbant d'extraction en phase solide à phase inverse avec un solvant organique polaire ;
(1.2) équilibrer le sorbant d'extraction en phase solide à phase inverse avec un mélange comprenant le solvant organique polaire et de l'eau ;
(1.3) charger les particules comprenant de la saponine et un lipide sur le sorbant d'extraction en phase solide à phase inverse ;
(1.4) laver le sorbant d'extraction en phase solide à phase inverse avec un mélange comprenant le solvant organique polaire et de l'eau ; et
(1.5) éluer les saponines du sorbant d'extraction en phase solide à phase inverse avec le solvant organique polaire, obtenant ainsi les saponines isolées dans un mélange comprenant les saponines isolées et le solvant organique polaire.

3. Procédé selon la revendication 2, dans lequel le solvant organique polaire comprend du méthanol.

4. Procédé selon la revendication 3, dans lequel les mélanges comprenant le solvant organique polaire et de l'eau dans une ou plusieurs des étapes (1.2) ou (1.4) comprennent du méthanol et de l'eau dans un rapport de 1:99 à 20:80 (V:V), de 2:98 à 10:90 (V:V), de 3:97 à 7:93 (V:V), ou d'environ 5:95 (V:V).

5. Procédé selon l'une quelconque des revendications 2 à 4, dans lequel, au cours de l'étape (1.3), les particules comprenant de la saponine et un lipide sont chargées sur le sorbant d'extraction en phase solide à phase inverse à une teneur en saponine de 0,1 mg à 2 mg, de 0,2 mg à 1 mg, de 0,3 mg à 0,7 mg, de 0,4 mg à 0,6 mg, ou d'environ 0,5 mg, par 500 mg de masse du lit du sorbant d'extraction en phase solide à phase inverse.

6. Procédé selon l'une quelconque des revendications 2 à 5, dans lequel le sorbant d'extraction en phase solide à phase inverse comprend un groupe actif octadécyle de sorbant.

7. Procédé selon l'une quelconque des revendications 2 à 6, dans lequel l'étape (1) comprend en outre une étape (1.6) consistant à ajouter de l'eau au mélange comprenant les saponines isolées et le solvant organique polaire jusqu'à une teneur finale en eau de 5 % à 20 %, de 7 % à 15 %, de 9 % à 12 %, ou d'environ 10 %, en volume.

8. Procédé selon l'une quelconque des revendications 1 à 7, dans lequel la quantité prédéterminée des particules comprenant de la saponine et un lipide est une teneur en saponine d'une formulation utilisée pour fabriquer les particules comprenant de la saponine et un lipide.

9. Procédé selon l'une quelconque des revendications 1 à 8, dans lequel le composé étalon interne comprend de l'acide maléique et le ou les protons du composé étalon interne comprennent deux protons oléfiniques magnétiquement équivalents de l'acide maléique.

10. Procédé selon l'une quelconque des revendications 1 à 9, dans lequel le spectre RMN quantitatif du proton est généré selon les paramètres suivants :
(a) un angle de basculement d'impulsion de 30° ;
(b) un délai de relaxation d'au moins 10 secondes ; et
(c) un temps d'acquisition d'au moins 2,7 secondes.

11. Procédé selon la revendication 10, dans lequel le spectre RMN quantitatif du proton est en outre généré selon un ou plusieurs des paramètres suivants :
(d) une température de 12-30 °C ;
(e) une intensité de champ d'au moins 400 MHz ou d'au moins 600 MHz ;
(f) une sonde à canal proton ayant un diamètre de sonde de 1 mm à 10 mm, par exemple 5 mm ;
(g) au moins 64 accumulations ou au moins 128 accumulations ou au moins 256 accumulations ;
(h) une largeur spectrale d'au moins 12 ppm ou d'au moins 16 ppm ; ou
(i) une fonction d'élargissement de raie d'au moins 0,3 Hz ou 1 Hz.

12. Procédé selon l'une quelconque des revendications 1 à 11, dans lequel l'étape (5) comprend une correction de phase manuelle, une correction polynomiale automatique de la ligne de base, un étalonnage de l'échelle de déplacement chimique, une correction polynomiale manuelle de la ligne de base et une intégration des signaux du spectre RMN quantitatif du proton.

13. Procédé selon la revendication 12, dans lequel le noyau triterpénique d'une ou plusieurs des saponines comprend en outre un groupe aldéhyde C23.

14. Procédé selon la revendication 13, dans lequel l'étalonnage de l'échelle de déplacement chimique comprend le réglage d'un pic principal du groupe aldéhyde C23 à 9,45 ppm.

15. Procédé selon l'une quelconque des revendications 12 à 14, dans lequel :
(i) la correction polynomiale manuelle de la ligne de base comprend la correction du signal pour les trois protons du groupe méthyle C26 du noyau triterpénique des saponines dans une plage de déplacement chimique de 0,60 à 0,85 ppm ; et/ou
(ii) l'intégration des signaux comprend l'application de limites d'intégration pour le signal pour les trois protons du groupe méthyle C26 du noyau triterpénique des saponines sur la base d'une plage de déplacement chimique de 0,73 à 0,85 ppm.

16. Procédé selon l'une quelconque des revendications 1 à 15, dans lequel l'étape (5) comprend la réalisation d'une normalisation d'aire du signal pour les trois protons du groupe méthyle C26 du noyau triterpénique des saponines et du signal pour le ou les protons du composé étalon interne afin de tenir compte des différences de nombres de protons magnétiquement équivalents de ceux-ci.

17. Procédé selon l'une quelconque des revendications 1 à 16, dans lequel le noyau triterpénique des saponines comprend en outre une position C3 et une position C28, et les saponines comprennent en outre un groupe disaccharide ou un groupe trisaccharide lié à la position C3 du noyau triterpénique, et un groupe oligosaccharide lié à la position C28 du noyau triterpénique.

18. Procédé selon la revendication 17, dans lequel le noyau triterpénique comprend un ou plusieurs parmi un noyau triterpénique d'acide quillaïque, un noyau triterpénique d'acide quillaïque 22β-OH, un noyau triterpénique d'acide phytolaccagénique, un noyau triterpénique d'acide phytolaccagénique 23-OAc, un noyau triterpénique de gypsogénine, ou un noyau triterpénique d'acide échinocystique.

19. Procédé selon la revendication 17 ou la revendication 18, dans lequel le groupe oligosaccharide comprend un groupe fucosyle comprenant une position O-3 et une position O-4.

20. Procédé selon la revendication 19, dans lequel une ou plusieurs des saponines comprennent en outre un groupe acyle gras et/ou un groupe acyle II liés à la position O-3 ou à la position O-4 du groupe fucosyle.

21. Procédé selon la revendication 20, dans lequel le spectre RMN du proton de la solution des saponines lyophilisées et de l'étalon interne inclut en outre un signal pour un ou plusieurs protons du groupe acyle gras lié à la position O-3 ou à la position O-4 du groupe fucosyle, et le procédé comprend en outre une étape (6) consistant à comparer le signal pour le ou les protons du groupe acyle gras lié à la position O-3 ou à la position O-4 du groupe fucosyle à un ou plusieurs parmi le signal pour les trois protons du groupe méthyle C26 du noyau triterpénique des saponines ou le signal pour le ou les protons du composé étalon interne.

22. Procédé selon l'une quelconque des revendications 1 à 21, dans lequel les saponines comprennent des saponines extraites de l'écorce de l'arbre à savon sud-américain Quillaja saponaria Molina.

23. Procédé selon l'une quelconque des revendications 1 à 22, dans lequel les particules comprenant de la saponine et un lipide comprennent un ou plusieurs parmi des particules de matrice iscom, des particules iscom présentatrices d'antigène, des particules Adjuvant System 01 à base de liposomes, ou des particules Army Liposome Formulation Q, ou bien sont constituées de ceux-ci.

24. Procédé selon l'une quelconque des revendications 1 à 23, dans lequel les lipides comprennent un ou plusieurs phospholipides et du cholestérol.

25. Procédé selon la revendication 24, dans lequel le ou les phospholipides comprennent une ou plusieurs phosphatidylcholines.

26. Procédé selon l'une quelconque des revendications 23 à 25, dans lequel les particules comprenant de la saponine et un lipide sont des particules de matrice iscom qui sont constituées essentiellement des saponines, du ou des phospholipides et du cholestérol.

27. Procédé selon l'une quelconque des revendications 23 à 25, dans lequel les particules comprenant de la saponine et un lipide sont des particules iscom présentatrices d'antigène qui sont constituées essentiellement des saponines, du ou des phospholipides, du cholestérol et d'un ou plusieurs antigènes.
